Europäisches Patentamt

European Patent Office

Office européen des brevets

(19)

(11) Veröffentlichungsnummer: **0 210 643**
**B1**

(12) # EUROPÄISCHE PATENTSCHRIFT

(45) Veröffentlichungstag der Patentschrift:
21.06.89

(21) Anmeldenummer: **86110437.0**

(22) Anmeldetag: **29.07.86**

(51) Int. Cl.⁴: **H 01 F 13/00**

(54) Vorrichtung zur Magnetimpulsbehandlung von ferromagnetischen Werkstoffen.

(30) Priorität: **29.07.85 BG 71263/85**

(43) Veröffentlichungstag der Anmeldung:
**04.02.87 Patentblatt 87/6**

(45) Bekanntmachung des Hinweises auf die Patenterteilung:
**21.06.89 Patentblatt 89/25**

(84) Benannte Vertragsstaaten:
**AT CH DE FR GB IT LI SE**

(56) Entgegenhaltungen:
**EP-A-0 101 922**
**FR-A-1 421 455**
**GB-A-2 156 608**

(73) Patentinhaber: **NPK ELEKTRONNA OBRABOTKA NA MATERIALITE I NOVI TECHNOLOGII, Orion, 30- 20- Str. 34, Sofia (BG)**

(72) Erfinder: **Makedonski, Boris Georgiev, E. Yossiff- Strasse 50, Sofia (BG)**
Erfinder: **Hristov, Vladimir Georgiev, Komplex Nadejda Block 603- 3, Sofia (BG)**
Erfinder: **Kirilov, Kiril Dimitrov, L. Karavelov- Strasse 81, Sofia (BG)**
Erfinder: **Pundev, Georgi Yantschev, Komplex Mladost- I Block 18- 7, Sofia (BG)**
Erfinder: **Mihailova, Janet Ivanova, 734- Strasse 3, Sofia (BG)**
Erfinder: **Todorov, Nedelcho Hristov, 21- 235, G. Izmirliev Strasse, Sofia (BG)**

(74) Vertreter: **Ebbinghaus, Dieter, v. FÜNER, EBBINGHAUS, FINCK Patentanwälte European Patent Attorneys Mariahilfplatz 2 & 3, D-8000 München 90 (DE)**

LIBER, STOCKHOLM 1989

## Beschreibung

Die Erfindung betrifft eine Einrichtung zur Magnetimpulsbehandlung von ferromagnetischen Werkstoffen, welche im Maschinenbau zur Veränderung der physikalisch-mechanischen Eigenschaften Anwendung findet.

Aus der BG-PS-38 909 ( = EP-A-0 101 922) ist eine Einrichtung zur Magnetimpulsbehandlung von ferromagnetischen Werkstoffen bekannt, welche einen Kraftinduktor und ein Steuersystem aufweist. Der Kraftinduktor weist eine Induktorspule, zwei Speiseeingänge, zwei Steuereingänge und einen Steuerausgang auf, und besteht aus zwei identischen Schaltungen, von denen jede eine Reihenschaltung aus der Wicklung der Induktorspule und einen Kondensator enthält, parallel zu denen ein Thyristor geschaltet ist. Der gemeinsame Punkt der Anode des Thyristors mit dem Kondensator ist an den entsprechenden Speiseeingang angeschlossen, und der gemeinsame Punkt der Kathode des Thyristors mit der entsprechenden Wicklung ist an Masse gelegt. Die Steuerelektrode jedes Thyristors ist an den entsprechenden Steuereingang des Induktors angeschlossen. Der Ausgang eines Startsdatengebers ist mit dem Steuerausgang verbunden. Das Steuersystem weist zwei Speiseausgänge auf, von denen jeder an den entsprechenden Speiseeingang des Kraftinduktors angeschlossen ist; zwei Steuerausgänge, von denen jede mit dem entsprechenden Steuereingang de Induktors verbunden ist; einen Steuereingang, welcher an den Steuerausgang des Induktors angeschlossen ist; einen Block zur Steuerung der Thyristoren, deren Ausgänge an den entsprechenden Steuerausgang angeschlossen sind; einen Steuerblock, dessen Eingang an den Steuerausgang und dessen Ausgang an den Eingang des Blocks zur Steuerung der Thyristoren angeschlossen sind. Ein zweiter Ausgang des Steuerblocks ist mit einem Steuereingang eines Speiseblocks verbunden, welcher als regelbarer stabilisierter Stromgleichrichter ausgeführt ist, dessen Ausgange an den entsprechenden Speisausgang angeschlossen sind. Der Wechselstromeingang des Speiseblocks ist an einen Wechselstromspeiseeingang des Steuersystems angeschlossen, welcher Eingang über einen zweiten Speiseblock an den Speiseeingang des Blocks zur Steuerung der Thyristor angeschlossen ist.

Ein Nachteil der Einrichtung ist die unzureichend wirksame Behandlung der Werkstoffe, verursacht durch die unzureichend guten Charakteristiken des Magnetfeldes, welche in eingeschränkter maximaler Magnetinduktion, Arbeitsfrequenz und Homogenität bestehen. Zu diesen Nachteilen kommt es infolge des Vorhandenseins von zwei Wicklungen in der Induktorspule, welche das Spektrum der Abmessungen des zu behandelnden Werkstoffs einschränken, und infolge des Vorhandenseins eines parasitären Magnetfeldes während der Ladung der Kondensatoren über die im Moment nicht arbeitende Wicklung.

Der Erfindung liegt die Aufgabe zugrunde, eine Vorrichtung zur Magnetimpulsbehandlung von ferromagnetischen Werkzeugen zu schaffen, bei der die Wirksamkeit der Behandlung des Werkstoffes durch Verbesserung der Charakteristiken des Magnetfeldes erhöht ist.

Diese Aufgabe wird erfindungsgemäß durch die im Patentanspruch 1 beschriebene Einrichtung gelöst.

Bevorzugte Weiterbildungen und Ausgestaltungen der erfindungsgemäßen Einrichtung sind Gegenstand der Patentansprüche 2 und 3.

Ein Vorteil der erfindungsgemäßen Vorrichtung ist die erhöhte Wirksamkeit der Behandlung des Werkstoffes, wodurch seine physikalisch-mechanischen Eigenschaften, z. B. seine Verschleißfestigkeit, verbessert werden. Ein anderer Vorteil ist die Möglichkeit, die Parameter des Einflußfeldes zu optimieren und zu automatisieren sowie die Möglichkeit zur Steuerung von mehr als einem Kraftinduktor und die Möglichkeit zum Anschluß der Vorrichtung an flexible automatisierte Fertigungssysteme. Außerdem ist durch die parallel zu jedem Kondensator geschaltete Diode der Energieaufwand verringert. Infolge der Möglichkeit der Vergrößerung des Durchmessers der Wicklung ist das Spektrum hinsichtlich des Durchmessers des zu behandelnden Werkstoffes erweitert und es besteht die Möglichkeit der Erhöhung der Qualität und der Verkürzung der Zeitdauer der Behandlung infolge der verbesserten Steilheit der Magnetimpulse.

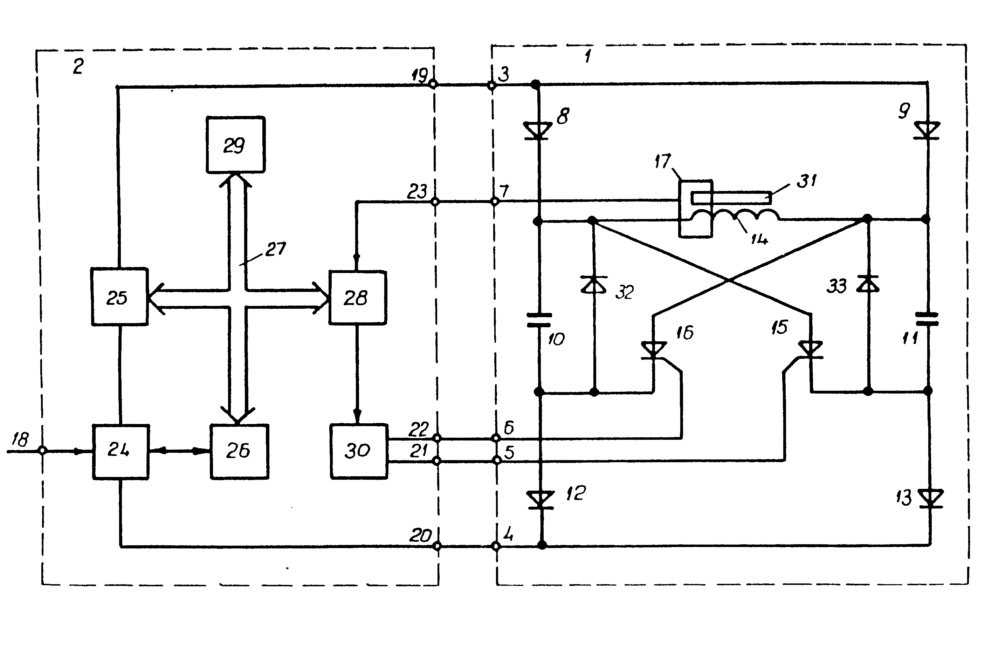

Die Erfindung wird anhand des in der Zeichnung gezeigten Ausführungsbeispiels erläutert. Die Zeichnung zeigt das Schaltbild einer erfindungsgemäßen Vorrichtung zur Magnetimpulsbehandlung von ferromagnetischen Werkstoffen.

Die Vorrichtung besteht aus einem Kraftinduktor 1 und einer Steueranordnung 2. Der Kraftinduktor 1 enthält zwei Speiseeingänge 3 und 4, zwei Steuereingänge 5 und 6, einen Steuerausgang 7 und zwei zueinander parallel geschaltete Reihenschaltungen aus je einer ersten Diode 8 bzw. 9, je einem Kondensator 10 bzw. 11 und je einer zweiten Diode 12 bzw. 13. Die Anoden der ersten Dioden 8, 9 sind an den einen Speiseeingang 3 und die Kathoden der zweiten Dioden 12, 13 an den anderen Speiseeingang 4 angeschlossen. An die Verbindungspunkte der ersten Dioden 8, 9 mit den Kondensatoren 10, 11 sind die Wicklung 14 einer Induktorspule und die Anode eines Thyristors 15 bzw. 16 angeschlossen dessen Kathode mit dem anderen Anschluß des an den anderen Thyristor 16, 15 angeschlossenen Kondensators 11, 10 verbunden ist. Die Steuerelektroden der Thyristoren 15, 16 sind mit dem Steuereingang 5 bzw. 6 des Induktors 1 verbunden. An die Wicklung 14 ist ein Rückkopplungsdatengeber 17 angeschlossen, dessen Ausgang mit dem Steuerausgang 7 des Induktors 1 verbunden ist. Die Steueranordnung 2 weist einen Wechselstromspeiseeingang 18, zwei Speiseausgänge 19, 20, zwei Steuerausgänge 21, 22, einen Steuereingang 23 und einen Speiseblock 24 auf. Der Eingang des Speiseblocks 24 ist an den Wechselstromeingang 18 angeschlossen. Der eine Ausgang des Speiseblocks 24 ist über einen regelbaren Schlüssel 25, der als elektronischer Schalterregler ausgeführt ist, mit dem einen Speiseausgang 19 verbunden, während der andere Ausgang des Speiseblocks 24 direkt mit dem Speiseausgang 20 verbunden ist. Ein Synchronisierblock 26 ist zweiseitig an den Speiseblock 24 angeschlossen. Der Synchronisierblock 26 ist ferner über ein Interface 27 an den steuerbaren Schalter 25, an einen lokalen Steuerblock 28 und an einen programmierbaren Steuer- und Anzeigeblock 29 angeschlossen. Ein Ausgang des lokalen Steuerblocks 28 ist an einen Steuerblock 30 zur Steuerung der Thyristoren 15, 16 angeschlossen, während sein Steuereingang an den Steuereingang 23 der Steueranordnung 2 angeschlossen ist. Die Speiseausgänge 19, 20 der Steueranordnung 2 sind mit dem entsprechenden Speiseeingang 3 bzw. 4 des Induktors 1 verbunden. Die Steuerausgänge 21, 22 der Steueranordnung 2 sind mit den entsprechenden Steuereingängen 5 bzw. 6 des Induktors 1 verbunden, dessen Steuerausgang 7 an den Steuereingang 23 der Steueranordnung 2 angeschlossen ist. Parallel zu jedem Kondensator 10 bzw. 11 des Kraftinduktors 1 ist eine Diode 32 bzw. 33 geschaltet, deren Kathode an den Verbindungspunkt zwischen Wicklung 14 und Kondensator 10 bzw. 11 angeschlossen ist und deren Anode mit dem Verbindungspunkt zwischen dem entsprechenden Kondensator 10 bzw. 11 mit der Kathode des entsprechenden Thyristors 16 bzw. 15 verbunden ist.

Die Vorrichtung arbeitet folgendermaßen:

Das zu behandelnde Werkstück 31 wird in die Wicklung 14 eingelegt, wobei vom Speiseblock 24 über den steuerbaren Schalter 25 dem einen Speiseausgang 19 gegenüber dem anderen Speiseausgang 20 positives Potential zugeführt wird. Die Potentiale von den Speiseausgängen 19, 20 der Steueranordnung 2 werden über die Speiseeingänge 3, 4 des Kraftinduktors 1 den Anoden der ersten Dioden 8, 9 und den Kathoden der zweiten Dioden 12, 13 zugeführt, die eingeschaltet werden. Infolgedessen werden die Kondensatoren 10, 11 auf eine Spannung aufgeladen, die von der Spannung der Speisequelle 24, der Zeitdauer des Anschlusses des steuerbaren Schalters 25 und von der Zeitkonstante ihrer Ladeschaltung (Widerstand der eingeschalteten Dioden 8, 12 bzw. 9, 13 und Wert der Kapazität des entsprechenden Kondensators 10 bzw. 11) bestimmt wird. Danach werden vom Steuerblock 30 den Steuerelektroden der Thyristoren 15, 16 zu verschiedenen Zeitpunkten Steuerimpulse zugeführt. Infolgedessen entlädt sich der eine Kondensator, z. B. der Kondensator 10, zu einem bestimmten Zeitpunkt über die Wicklung 14 und den eingeschalteten Thyristor 16. Der Strom fließt in einer bestimmten Richtung durch die Wicklung 14. Im nächsten Moment, bei Zufuhr eines Steuerimpulses zum anderen Thyristor 15, entlädt sich der andere Kondensator 11, und durch die Wicklung 14 fließt ein Strom in entgegengesetzter Richtung. Die Ströme mit verschiedenen Richtungen, die zu den beiden Zeitpunkten erhalten werden, erzeugen ein Magnetimpulsfeld mit zwei Polen, das die physikalisch-mechanischen Eigenschaften des zu behandelnden Werkstoffes beeinflußt. Die Magnetisierung und Entmagnetisierung im Magnetimpulsfeld lag bei experimentellen Untersuchungen im Bereich einer Minute.

Bei Vorhandensein der Dioden 32, 33 wird nach der vollständigen Entladung jedes Kondensators 10 bzw. 11 in die Wicklung 14 eine Selbst-EMK induziert, die an der Anode des bis zu diesem Zeitpunkt eingeschalteten Thyristors 16 bzw. 15 positiv und an der Kathode der Diode 32, 33 negativ ist, die an den gerade entladenen Kondensator 10 bzw. 11 angeschlossen ist. Als Ergebnis bleibt der Thyristor 16 bzw. 15 auch nach der vollständigen Entladung des entsprechenden Kondensators 10 bzw. 11 eingeschaltet und die Diode 32 bzw. 33 wird eingeschaltet. Deshalb fließt in der Schaltung des eingeschalteten Thyristors 16 bzw. 15 und der Diode 32 bzw. 33 infolge der durch die Selbstinduktion induzierten EMK ein Strom. Dieser Strom trägt zur Verminderung und Eliminierung der Spannung bei, wodurch ein Nachladen des entsprechenden Kondensators 10 bzw. 11 auf eine Spannung mit einer Polarität vermieden wird, die der Arbeitspolarität entgegengesetzt ist, nämlich die, die von seiner Ladung verursacht wurde. Die Kondensatoren 10, 11 können mit einem Pol sein. Außerdem ist wegen der eliminierten selbstinduzierten Gegen-EMK in der Wicklung 14 die Steilheit der Front der Magnetimpulse verbessert, wodurch die Wirksamkeit der Behandlung erhöht und die Behandlungsdauer verkürzt wird.

Über den programmierbaren Steuer- und Anzeigeblock 29, der durch den Synchronisierblock 26 mit der Frequenz der Speisewechselspannung synchronisiert ist, wird ein bestimmter Algorithmus der Steuerung des steuerbaren Schalters 25, durch den die Ladespannung des entsprechenden Kondensators 10, 11 bestimmt wird, und ein bestimmter Algorithmus der Betriebsweise des lokalen Steuerblocks 28 vorgegeben, der seinerseits den Steuerblock 30 der Thyristoren 15, 16 steuert. Durch sie wird die Reihenfolge und der Zeitpunkt des Einschaltens der Thyristoren 15, 16 bestimmt. Auf diese Weise werden die Intensität, die Polarität und die Frequenz der auf das Werkstück 31 einwirkenden Magnetimpulse vorgegeben, die von der Wicklung 14 erzeugt werden. Die Behandlung wird vom Rückkopplungsdatengeber 17 kontrolliert und von dem lokalen Steuerblock 28 und dem programmierbaren Steuer- und Anzeigeblock 29 optimiert. Nach Abschluß der Behandlung wird das Werkstück 31 entmagnetisiert.

Die erfindungsgemäße Vorrichtung wurde experimentell untersucht, indem Schraubenbohrer mit einem Durchmesser von 4,8 mm behandelt wurden. Die Schneidebedingungen nach der Behandlung sind: Schneidegeschwindigkeit 24,13 m/min, 1600 Drehungen/min, Zufuhrschritt 0,1 mm/Drehung, Tiefe der Behandlung 15 mm, Material: Bogenstahl ST 45, Abkühlung mit 5 prozentiger Lösung von Sulphuröl im Wasser.

Mit der erfindungsgemäßen Vorrichtung behandelte Bohrer sind doppelt so verschleißfest wie mit der bekannten Vorrichtung behandelte.

## Patentansprüche

1. Vorrichtung zur Magnetimpulsbehandlung von ferromagnetischen Werkstoffen, mit einem Kraftinduktor (1) und einem Steuergerät (2), wobei der Kraftinduktor (1) eine Induktorspule (14), zwei Speiseeingänge (3, 4), von denen jeder an einen entsprechenden Speiseausgang (19, 20) der Steueranordnung (2) angeschlossen ist, und zwei Steuereingänge (5, 6), von denen jeder mit einem entsprechenden Steuerausgang (21, 22) der Steueranordnung verbunden ist, wobei der Steuerausgang (7) des Kraftinduktors (1) an den Steuereingang (23) der Steueranordnung (1) angeschlossen ist und die Anoden zweier Thyristoren (15, 16) an den einen Anschluß eines entsprechenden Kondensators (10, 11) angeschlossen sind, und wobei die Steueranordnung (2) einen Speiseblock (24) enthält, dessen Eingang an einen Wechselstromeingang (18) und der eine Ausgang an den einen Speiseausgang (20) angeschlossen ist, während der Eingang des Steuerblocks (28) an den Steuereingang (23) und sein Ausgang an den Eingang eines Steuerblocks (30) zur Steuerung der Thyristoren (15, 16) angeschlossen ist deren Steuerelektroden mit dem entsprechenden Steuerausgang (21, 22) verbunden sind, dadurch gekennzeichnet, daß die Induktorspule eine Wicklung (14) aufweist, die zwischen die Verbindungspunkte der Thyristoren (15, 16) mit den Kondensatoren (10, 11) und den Kathoden der entsprechenden ersten Diode (8, 9) geschaltet ist, deren Anode mit dem einen Speiseeingang (3) des Kraftinduktors (1) verbunden ist, daß die Kathode jedes Thyristors (15, 16) an den anderen Anschluß des mit dem anderen Thyristor (15, 16) verbundenen Kondensators (10, 11) und an die Anode einer entsprechenden zweiten Diode (12, 13) angeschlossen ist, deren Kathode mit dem anderen Speiseeingang (4) des Kraftinduktors (1) verbunden ist und daß zwischen den anderen Ausgang des Speiseblocks (24) der Steueranordnung (2) und dessen anderen Speiseausgang (19) ein steuerbarer Schalter (25) geschaltet ist.

2. Vorrichtung nach Anspruch 1, dadurch gekennzeichnet, daß der Steuerblock (28) lokal ist und über ein Interface (27) an einen programmierbaren Steuer- und Anzeigeblock (29), an einen Synchronisierblock (26) und an den Steuereingang des Schalters (25) angeschlossen ist, wobei der Synchronisierblock (26) zweiseitig mit dem Speiseblock (24) verbunden ist.

3. Vorrichtung nach Anspruch 1, dadurch gekennzeichnet, daß parallel zu jedem Kondensator (10, 11) eine Diode (32, 33) geschaltet ist, deren Kathode jeweils an ein Ende der Wicklung (14) angeschlossen ist.

## Claims

1. A device for treating ferromagnetic materials with magnetic pulses, comprising a power inductor (1) and a control device (2), the power inductor (1) comprising an inductor coil (14), two supply inputs (3 4), each of which is connected to a corresponding supply output (10, 20) of the control arrangement (2), and two control inputs (5, 6), each of which is connected to a corresponding control output (21, 22) of the control arrangement, the control output (7) of the power inductor (1) being connected to the control input (23) of the control arrangement (2) and the anodes of two thyristors (15, 16) being connected to one connection of a corresponding condenser (10, 11), and the control arrangement (2) comprising a supply block (24), whose input is connected to an a.c. input (18) and whose first output is connected to one supply output (20), wheres the input of the control block (28) is connected to the control input (23) and its output to the input of a control block (30) for controlling the thyristors (15, 16), whose control electrodes are connected to the corresponding control output (21, 22), characterised in that the induction coil comprises a winding (14), which is connected between the connection points of the thyristors (15, 16) with the condensers (10, 11) and the cathodes of the corresponding first diode (8, 9) whose anode is connected to one supply input (3) of the power inductor (1), in that the cathode of each thyristor (15, 16) is connected to the other connection of the condenser (10, 11) connected with the other thyristor (15, 16) and to the anode of corresponding second diode (12, 13), whose cathode is connected to the other supply input (4) of the power inductor (1) and in that a controllable switch (25) is connected between the other output of the supply block (24) of the control arrangement (2) and its other supply output (19).

2. A device according to claim 1, characterised in that the control block (28) is local and is connected via an interface (27) to a programmable control and display block (29), to a synchronising block (26) and to the control input of the switch (25), the synchronising block (26) being connected on two sides with the supply block (24).

3. A device according to claim 1, characterised in that a diode (32, 33), whose cathode is connected in each case to one end of the winding (14), is connected in parallel with each condenser (10, 11).

**Revendications**

1. Dispositif pour le traitement, par impulsions magnétiques, de matériaux ferromagnétiques, comportant un inducteur de force (1) et un appareil de commande (2), et dans lequel l'inducteur de force (1) contient une bobine d'induction (14), deux entrées d'alimentation (3, 4) dont chacune est reliée à une sortie d'alimentation correspondante (19, 20) de l'installation de commande (2), et deux entrées de commande (5, 6) dont chacune est reliée à une sortie de commande correspondante (21, 22) de l'installation de commande, étant précisé que la sortie de commande (7) de l'inducteur de force (1) est reliée à l'entrée de commande (23) de l'installation de commande (1) et que les anodes de deux thyristors (15, 16) sont reliées à l'une des bornes d'un condensateur correspondant (10, 11), et étant précisé que l'installation de commande (2) contient un bloc d'alimentation (24) dont l'entrée est reliée à une entrée de courant alternatif (18) et dont l'une des sorties est reliée à l'une des sorties d'alimentation (20), tandis que l'entrée du bloc de commande (28) est reliée à l'entrée de commande (23) et que sa sortie est reliée à l'entrée d'un bloc de commande (30) qui est prévu pour la commande des thyristors (15, 16) et dont les électrodes de commande sont reliées à la sortie de commande correspondante (21, 22), caractérisé en ce que la bobine d'induction présente un bobinage (14) qui est mis en circuit entre les points de liaison des thyristors (15, 16) avec les condensateurs (10, 11) et avec les cathodes de la première diode correspondante (8, 9) dont l'anode est reliée à l'une des entrées d'alimentation (3) de l'inducteur de force (1), en ce que la cathode de chaque thyristor (15, 16) est reliée à l'autre borne du condensateur (10, 11), relié à l'autre thyristor (15, 16), et à l'anode d'une seconde diode correspondante (12, 13) dont la cathode est reliée à l'autre entrée d'alimentation (4) de l'inducteur de force (1), et en ce qu'un interrupteur que l'on peut commander (25) est mis en circuit entre l'autre sortie du bloc d'alimentation (24) de l'installation de commande (2) et l'autre sortie d'alimentation (19) de cette installation de commande.

2. Dispositif selon la revendication 1, caractérisé en ce que le bloc de commande (28) est local et est relié, par l'intermédiaire d'une interface (27), à un bloc programmable de commande et d'affichage (29), à un bloc de synchronisation (26) et à l'entrée de commande de l'interrupteur (25), étant précisé que le bloc de synchronisation (26) est relié en bidirectionnel au bloc d'alimentation (24).

3. Dispositif selon la revendication 1, caractérisé en ce qu'en parallèle sur chaque condensateur (10, 11) est branchée une diode (32, 33) dont la cathode est reliée à une extrémité respective du bobinage (14).

1